# EUROPEAN PATENT APPLICATION

(11) **EP 4 672 770 A1**
(43) Date of publication of application: **31.12.2025**
(21) Application number: 24806288.7
(22) Date of filing: 19.04.2024
(51) Int. Cl.: H04N 23/52, G03B 17/55

(54) **CAMERA MODULE HAVING HEATING FUNCTION**

(30) Priority: 12.05.2023 CN 202310532862
(71) Applicant: Zhejiang Sunny Smartlead Technologies Co., Ltd., Yuyao, Zheijiang 315400 (CN)
(72) Inventor: ZHANG, Kouwen, Ningbo, Zhejiang 315400 (CN); XU, Yi, Ningbo, Zhejiang 315400 (CN); XU, Chentao, Ningbo, Zhejiang 315400 (CN)
(74) Representative: Petraz, Gilberto Luigi
(86) International application number: PCT/CN2024/088782
(87) International publication number: WO 2024/234931

(57) **Abstract**

A camera module (100) having a heating function is provided, including a lens (10), an electric heating apparatus (30), a circuit board (20), and a housing (40). The lens (10) includes a lens barrel (11) and a lens group (13) mounted in the lens barrel (11), the electric heating apparatus (30) includes an electric connecting portion (31) and an electric heating portion (32), and the electric heating portion (32) is located in the lens barrel (11). The circuit board (20) is provided with a second conductive connector (21), and a first conductive connector (33) is connected to the second conductive connector (21). A through hole (112) is provided on a barrel wall of the lens barrel (11), and the lens barrel (11) is penetrated out by the electric connecting portion (31) through the through hole (112). The lens (10) is mounted at a position of a lens element mounting portion (41), and the circuit board (20) is disposed in the housing (40).

## Description

### CROSS-REFERENCE TO RELATED APPLICATION

This application claims priority to Chinese patent application No. 202310532862.8, filed on May 12, 2023, and titled "CAMERA MODULE HAVING HEATING FUNCTION". The content of the above identified application is hereby incorporated by reference in its entirety.

### TECHNICAL FIELD

The present invention relates to the field of imaging device technologies, and in particular, to a camera module having a heating function.

### BACKGROUND

With rapid development in automobile intelligence, the application technology of vehicle-mounted camera modules has become increasingly mature, and more and more vehicles are equipped with a camera module as a component of an advanced driving assistance system. Due to a changing driving environment, a lens element at a front end of a lens of the camera module may fog or even freeze at different temperatures, resulting in unclear imaging, which cannot achieve a required function thereof. In order to solve the fogging problem of the lens, a heating coil powered by a conductive line, a power-supply circuit board, and a connector to realize electric heating of the lens may be wound outside the lens. In the foregoing manner, the heating coil is wound and exposed to a periphery of the lens, so that the heating coil cannot be waterproof, and influencing factors such as external airflows also easily affect a heating effect of the heating coil on the lens. Although the connector is used to connect the conductive line and the power-supply circuit board to implement a plugging and unplugging function, due to a relatively large area and volume occupied by a plugging structure using the connector, it does not facilitate volume control and miniaturization of the camera module. Manufacturing costs of the camera module by using the connector are also relatively high.

### SUMMARY

An objective of the present invention is to provide a camera module having a heating function.

A camera module having a heating function includes a lens, an electric heating apparatus, a circuit board, and a housing. The lens includes a lens barrel and a lens group mounted in the lens barrel. The electric heating apparatus includes an electric connecting portion and an electric heating portion, an end of the electric connecting portion is electrically connected to the electric heating portion, another end of the electric connecting portion is provided with a first conductive connector, and the electric heating portion is located in the lens barrel. The circuit board is provided with a second conductive connector, and the first conductive connector is welded to the second conductive connector. The circuit board is provided with a power-supply circuit electrically connected to the second conductive connector. A through hole is provided on a barrel wall of the lens barrel, the through hole is proximal to the circuit board, and the lens barrel is penetrated out by the electric connecting portion through the through hole. The housing is provided with a lens element mounting portion for mounting the lens, the lens is mounted at a position of the lens element mounting portion, and the circuit board is disposed in the housing.

In the camera module having the heating function, furthermore, the electric connecting portion includes a flexible circuit board, or the electric connecting portion includes a wire. According to the foregoing technical solution of the present invention, due to a small thickness of the flexible circuit board, more internal space of the camera module may be saved. A conductive connection of electric elements may be realized through the wire, which has an advantage of taking a wider range of materials.

In the camera module having the heating function, furthermore, the electric connecting portion includes a flexible circuit board. The electric heating portion includes an electric heating sheet, and the electric heating sheet includes a substrate and a heating wire arranged inside the substrate or on a surface of the substrate. Alternatively, the electric heating portion includes a heating wire formed on a surface of the flexible circuit board or inside the flexible circuit board.

In the camera module having the heating function, furthermore, the lens group includes two or more lens elements arranged at intervals along an optical axis of the lens, and the electric heating portion is disposed at an inner side of one of the two or more lens elements corresponding to a light incident end of the lens. According to the foregoing technical solution of the present invention, a temperature at the inner side of the one of the two or more lens elements may be increased more directly and quickly by the electric heating portion, thereby avoiding a fogging problem of the lens.

In the camera module having the heating function, furthermore, the circuit board is disposed at a light emitting end of the lens, the circuit board is connected and fixed to the lens barrel, and a photosensitive element disposed on the circuit board is configured to convert light emitted by the lens into an image signal. According to the foregoing technical solution of the present invention, in an aspect, a distance between the electric heating portion and a second circuit board may be reduced according to the above structure, so that a connection between the electric heating portion and the circuit board may be realized by a shorter electric connecting portion. In another aspect, a temperature drift of the camera module may be more stable by the fixed connection between the circuit board and the lens barrel, thereby obtaining more stable imaging quality.

In the camera module having the heating function, furthermore, the electric connecting portion located inside the lens barrel is denoted as an inner electric connecting portion, the electric connecting portion located outside the lens barrel is denoted as an outer electric connecting portion, and the outer electric connecting portion is connected to an outer wall of the lens barrel by bonding. According to the foregoing technical solution of the present invention, a part of the electric connecting portion (the outer electric connecting portion) located outside the lens barrel may be fastened to the lens barrel, to prevent the electric connecting portion from protruding outward and affecting layout and mounting of other components in the housing. In addition, the inner electric connecting portion may be hidden inside the lens barrel without affecting aesthetics of an external portion of the lens barrel that may be exposed outside the housing.

In the camera module having the heating function, furthermore, an inner wall of the lens barrel is provided with an accommodating groove, and the accommodating groove is configured to accommodate the inner electric connecting portion. According to the foregoing technical solution of the present invention, the inner electric connecting portion may be disposed in the accommodating groove, to avoid impact of the inner electric connecting portion on layout and mounting of the lens group in the lens barrel.

In the camera module having the heating function, furthermore, a sealing member is provided at a position of the electric connecting portion corresponding to the through hole. According to the foregoing technical solution of the present invention, the lens element and the lens barrel may be in a sealed connection, the electric heating portion is disposed in the lens barrel, and then sealing between the electric connecting portion and the lens barrel may be implemented by the sealing member, thereby implementing waterproof of the heating coil.

In the camera module having the heating function, furthermore, the electric heating portion is in an annular shape, and the electric heating portion is disposed at the inner side of the one of the two or more lens elements corresponding to the light incident end of the lens.

In the camera module having the heating function, furthermore, a heat-conducting medium is provided between the electric heating portion and the one of the two or more lens elements corresponding to the light incident end of the lens.

In the camera module having the heating function, the electric heating portion is located in the lens barrel, to avoid contact between the electric heating portion and an external environment, and implement waterproof of the electric heating portion. Meanwhile, since the electric heating portion is internally disposed in the lens barrel, it may also be avoided that the influence of influencing factors such as external airflows on a heating effect of the electric heating portion on the lens. It may overcome a problem of space occupation when a connector is used for plugging that the first conductive connector is connected to the second conductive connector by welding, and it may be easy to realize volume control and miniaturization design of the camera module.

### BRIEF DESCRIPTION OF THE DRAWINGS

To describe the technical solutions in the embodiments of the present invention or the related art more clearly, the following briefly describes the accompanying drawings required for describing the embodiments or the related art. Apparently, the accompanying drawings in the following description show merely the embodiments of the present invention, and one skilled in the art may still derive other drawings from the disclosed accompanying drawings without creative efforts.
FIG. 1 is a schematic three-dimensional diagram of a camera module having a heating function in a first embodiment of the present invention.
FIG. 2 is a schematic cross-sectional diagram of the camera module having the heating function in the first embodiment of the present invention.
FIG. 3 is a schematic diagram of an electric connecting portion in the first embodiment.
FIG. 4 is a schematic diagram of an electric connecting portion in a second embodiment.
FIG. 5 is a schematic diagram of a connecting manner between a lens barrel and a circuit board in an embodiment.
FIG. 6 is an enlarged diagram of a lower portion of FIG. 5.
FIG. 7 is a schematic cross-sectional diagram of the camera module having the heating function in the first embodiment of the present invention.

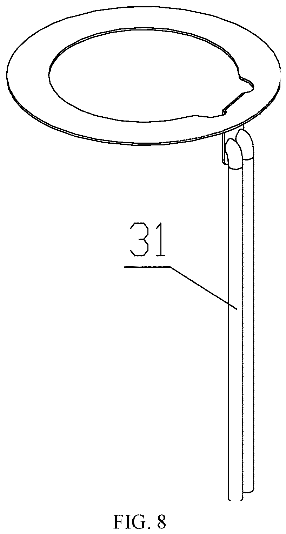

FIG. 8 is a schematic structural diagram of an electric heating portion in an embodiment of the present invention.

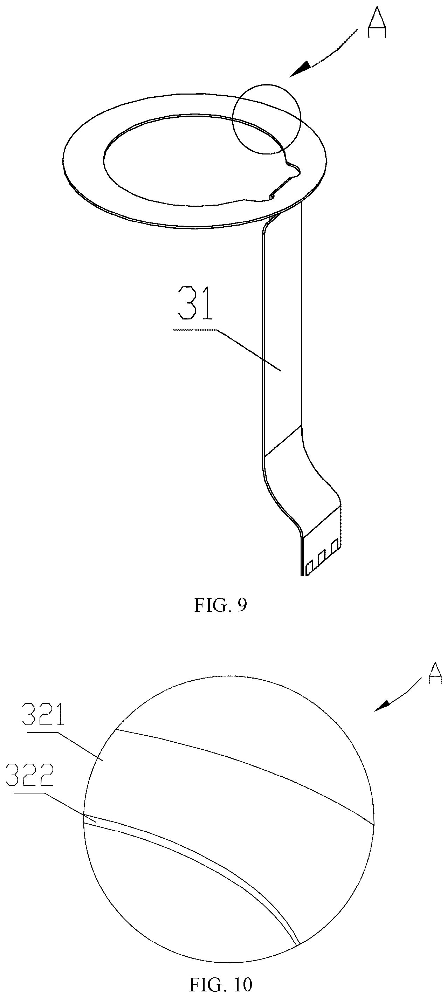

FIG. 9 is a schematic structural diagram of an electric heating portion in an embodiment of the present invention.
FIG. 10 is an enlarged diagram of a part A of FIG. 9.

In the drawings, a member list represented by each reference numeral is as follows.

100 represents a camera module, 10 represents a lens, 11 represents a lens barrel, 111 represents an accommodating groove, 112 represents a through hole, 12 represents a lens element, 13 represents a lens group, 14 represents a light incident end, 15 represents a light emitting end, 20 represents a circuit board, 21 represents a second conductive connector, 22 represents a photosensitive element, 30 represents an electric heating apparatus, 31 represents an electric connecting portion, 311 represents an inner electric connecting portion, 312 represents an outer electric connecting portion, 313 represents a sealing member, 32 represents an electric heating portion, 321 represents a substrate, 322 represents a heating wire, 33 represents a first conductive connector, 34 represents a heat-conducting medium, 40 represents a housing, and 41 represents a lens element mounting portion.

### DETAILED DESCRIPTION

The technical solutions in the embodiments of the present invention will be described clearly and completely with reference to the accompanying drawings in the embodiments of the present invention. Apparently, the described embodiments are merely some rather than all of the embodiments of the present invention. Based on the embodiments of the present invention, all other embodiments obtained by one skilled in the art without creative efforts fall within the protection scope of the present invention. Similar terms such as "include" or "comprise" used in the present invention mean that elements listed after the term are covered by an element before the term, and that other elements are not rule out

Unless otherwise defined, all terms (including technical or scientific terms) used in the present invention have the same meaning as commonly understood by one skilled in the art to which the present invention belongs. It will be further understood that terms, such as those defined in commonly used dictionaries, should be interpreted as having a meaning that is consistent with the meaning in the context of the related art and will not be interpreted in an idealized or extremely formal sense unless expressly defined herein.

Members, parameters such as specific models of the members, interrelationships between the members, and control circuits, which are not described in detail in the description, may be considered as technologies, methods, and devices known to one skilled in the art. However, in an appropriate situation, the technologies, methods, and devices shall be considered as a part of the description.

An arrow direction that is not marked in the accompanying drawings of the present invention may be a light direction.

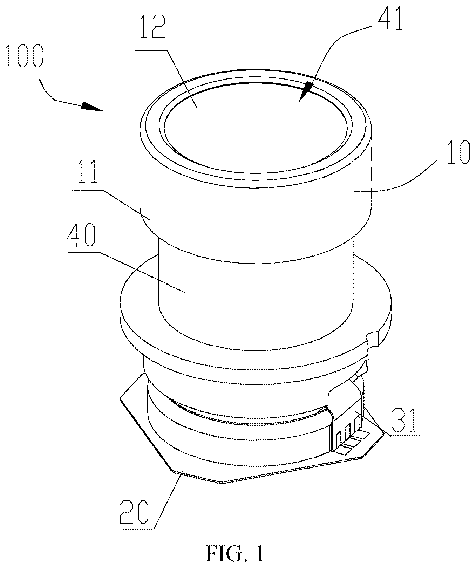

A camera module 100 having a heating function in an embodiment of the present invention is described with reference to FIG. 1 to FIG. 4, and includes a lens 10, an electric heating apparatus 30, a circuit board 20, and a housing 40.

The lens 10 includes a lens barrel 11 and a lens group 13 mounted in the lens barrel 11. The lens barrel 11 may generally have a hollow cylindrical structure, and the lens barrel 11 may be made of plastic (PC (Polycarbonate) or ABS (Acrylonitrile Butadiene Styrene)) or metal (stainless steel or aluminum). The lens group 13 arranged in the lens barrel 11 may usually include a plurality of lens elements, which include one lens element 12 of the plurality of lens elements corresponding to a light incident end 14 of the lens 10. After the camera module 100 is mounted to a vehicle, since the vehicle may be used in a low temperature condition, when a temperature of an outer side of the lens element 12 is lower than a temperature of an inner side of the lens element 12, a vapor at the inner side of the lens element 12 may be condensed into water mist on the inner side of the lens element 12, which affects an imaging effect of the lens 10.

The electric heating apparatus 30 includes an electric connecting portion 31 and an electric heating portion 32, an end of the electric connecting portion 31 is electrically connected to the electric heating portion 32, another end of the electric connecting portion 31 is provided with a first conductive connector 33, and the electric heating portion 32 is located in the lens barrel 11. When the electric heating portion 32 is conducted with a power-supply circuit by the electric connecting portion 31, the electric heating portion 32 may generate heat to increase a temperature in the lens barrel 11, so that the temperature in the lens barrel 11 (the temperature at the inner side of the lens element 12) may be equal to or higher than the temperature at the outer side of the lens element 12(an environment temperature), thereby avoiding the fogging problem of the lens.

The circuit board 20 is provided with a second conductive connector 21, and the first conductive connector 33 is welded to the second conductive connector 21. The circuit board 20 is provided with a power-supply circuit electrically connected to the second conductive connector 21. It may overcome a problem when the connector is used for plugging that the first conductive connector is connected to the second conductive connector by welding, and the problem is that the connector occupies a large space, which affects miniaturization of the camera module 100 and full utilization of an internal space of the camera module 100. A welding method may include solder spraying welding, a solder spraying welding process may be implemented by a machine, a production process may have high consistency, and a good electric connection between the first conductive connector 33 and the second conductive connector 21 may be achieved. Since there is a relatively enclosed structure in the lens barrel 11, when the electric heating portion 32 is used to heat the space at the inner side of the lens element 12, it may not need a large heating power, nor may it need the electric heating portion 32 to operate continuously, so a heating temperature may be controlled by whether there is a current in the power-supply circuit, a magnitude of the current, etc.

A through hole 112 is provided on a barrel wall of the lens barrel 11, the through hole 112 is proximal to the circuit board 20, and the lens barrel 11 is penetrated out by the electric connecting portion 31 through the through hole 112. In an aspect, the electric connecting portion 31 may be partially located inside the lens barrel 11 and partially located outside the lens barrel 11. Since the electric connecting portion 31 is partially located inside the lens barrel 11, it may be solved that the problem of poor aesthetics and occupation of layout space of other members caused by a fact that the electric connecting portion 31 is completely exposed outside the lens barrel 11.

The housing is provided with a lens element mounting portion 41 for mounting the lens 10, the lens 10 is mounted at a positon of the lens element mounting portion 41, and the circuit board 20 is disposed in the housing. The housing may include an integrated housing, or may be assembled by splicing a first housing and a second housing. It may prevent the electric heating apparatus 30 from being exposed, avoid loss of heating heat, and make appearance of the camera module 100 more aesthetic by arranging the electric heating apparatus 30 in the lens barrel 11.

In the camera module 100 having the heating function in the foregoing embodiments of the present invention, the electric heating portion 32 is located in the lens barrel 11, to avoid contact between the electric heating portion 32 and an external environment, and implement waterproof of the electric heating portion 32. Meanwhile, since the electric heating portion 32 is internally disposed in the lens barrel 11, it may also be avoided that the influence of influencing factors such as external airflows on a heating effect of the electric heating portion 32 on the lens 10. It may overcome a problem of space occupation when a connector is used for plugging that the first conductive connector 33 is connected to the second conductive connector 21 by welding, and it may be easy to realize volume control and miniaturization design of the camera module 100.

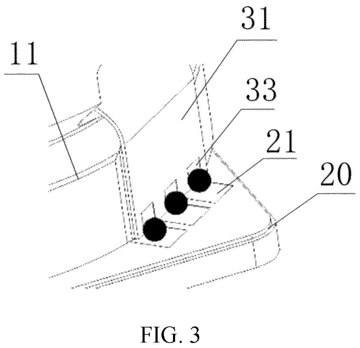

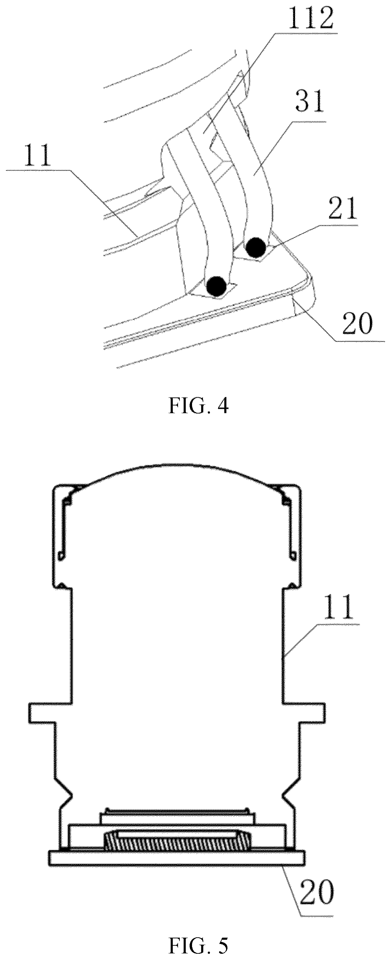

In the camera module 100 having the heating function in the foregoing embodiments of the present invention, it may have a plurality of specific implementations for the electric connecting portion 31, referring to FIG. 3, the electric connecting portion 31 may include a flexible circuit board, and an end of the flexible circuit board may be provided with the first conductive connector 33. Due to a small thickness of the flexible circuit board, more internal space of the camera module 100 may be saved. In another specific embodiment, referring to FIG. 4, the electric connecting portion 31 may include a wire, an end of the wire may be provided with the first conductive connector 33, and a conductive connection of electric elements may be realized through the wire, which has an advantage of taking a wider range of materials. A length of the flexible circuit board should be determined according to a distance between the electric heating apparatus 30 and the circuit board, and it should be ensured that the electric heating portion 32 is connected to the power-supply circuit.

In some embodiments, the electric connecting portion 31 may include a flexible circuit board. The electric heating portion 32 may include an electric heating sheet, and the electric heating sheet may include a substrate 321 and a heating wire 322 arranged inside the substrate or on a surface of the substrate 321. The substrate 321 may include a heat-resistant material such as a fiberglass cloth, a fiberglass mesh, or a refractory cotton. Alternatively, the electric heating portion 32 may include an electric heating wire formed on a surface of the flexible circuit board or inside the flexible circuit board, and the flexible circuit board may need to have good heat resistance during operation, and a temperature of the electric heating wire may be controlled to avoid damage to the flexible circuit board caused by overheating.

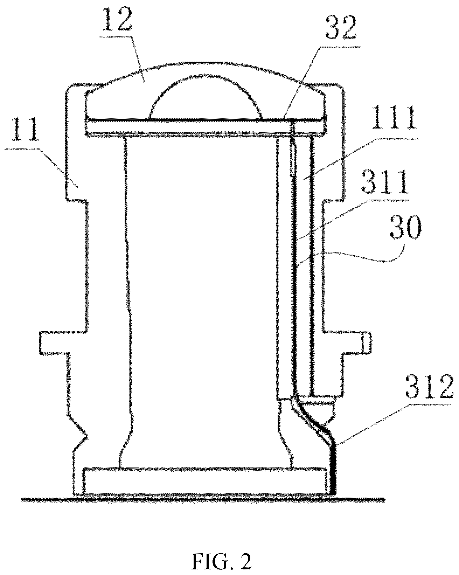

The electric heating portion 32 and the lens barrel 11 may be arranged in various ways, but since fogging usually occurs at the inner side of the lens element 12, alternatively, the lens group 13 may include two or more lens elements arranged at intervals along an optical axis of the lens 10, referring to FIG. 2, and the electric heating portion 32 may be disposed at the inner side of the lens element 12 corresponding to the light incident end 14 of the lens 10. Therefore, the temperature at the inner side of the lens element 12 may be increased more directly and quickly by the electric heating portion 32, thereby avoiding the fogging problem of the lens.

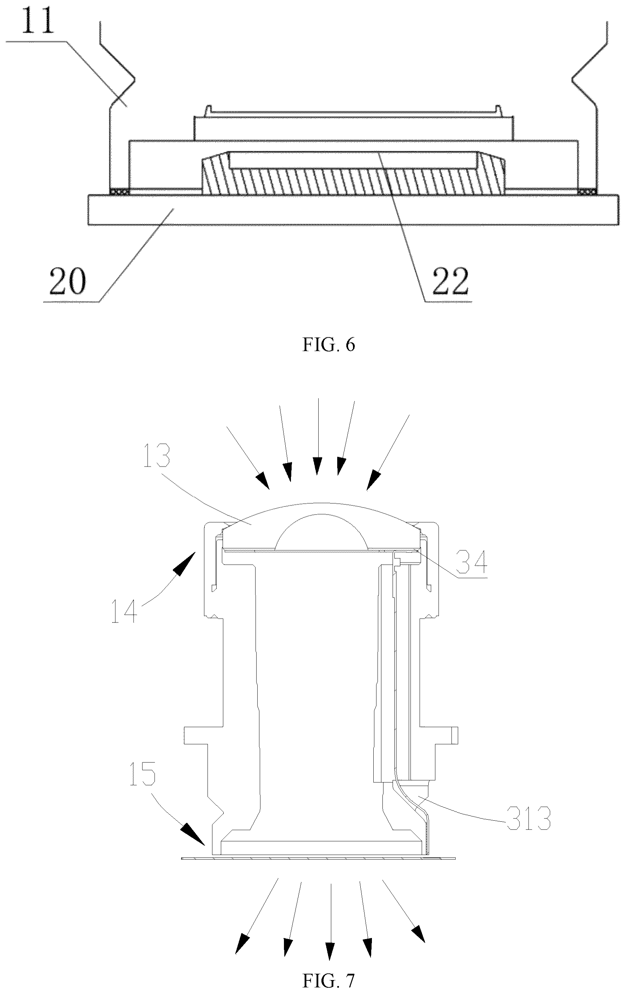

In another embodiment of the present invention, based on the structure of the foregoing embodiments, referring to FIG. 5 and FIG. 6, the circuit board 20 may be disposed at a light emitting end 15 of the lens 10, the circuit board 20 may be connected and fixed (e.g., bonded by an adhesive) to the lens barrel 11, and a photosensitive element 22 disposed on the circuit board 20 may be configured to convert light emitted by the lens 10 into an image signal. In an aspect, a distance between the electric heating portion 32 and the circuit board 20 may be reduced according to the above structure, so that a connection between the electric heating portion 31 and the circuit board 20 may be realized by a shorter electric connecting portion 31. In another aspect, a temperature drift of the camera module 100 may be more stable by the fixed connection between the circuit board 20 and the lens barrel 11, thereby obtaining more stable imaging quality.

In an alternative embodiment referring to FIG. 2, a through hole 112 is provided on a barrel wall of the lens barrel 11, the through hole 112 is proximal to the circuit board 20, and the lens barrel 11 is penetrated out by the electric connecting portion 31 through the through hole 112. The electric connecting portion 31 located inside the lens barrel 11 may be denoted as an inner electric connecting portion 311, the electric connecting portion 31 located outside the lens barrel 11 may be denoted as an outer electric connecting portion 312, and the outer electric connecting portion 312 may be connected to an outer wall of the lens barrel 11 by bonding (e.g., bonding is implemented by a glue or a double-sided tape). Based on the above structure, a part of the electric connecting portion (the outer electric connecting portion 312) located outside the lens barrel 11 may be fastened to the lens barrel 11, to prevent the electric connecting portion from protruding outward and affecting layout and mounting of other components in the housing. In addition, the inner electric connecting portion 311 may be hidden inside the lens barrel without affecting aesthetics of an external portion of the lens barrel 11 that may be exposed outside the housing. In a further alternative embodiment, an inner wall of the lens barrel 11 may be provided with an accommodating groove 111, and the accommodating groove 111 may be configured to accommodate the inner electric connecting portion 311. The inner electric connecting portion 311 may be disposed in the accommodating groove, to avoid impact of the inner electric connecting portion 311 on layout and mounting of the lens group 13 in the lens barrel.

In some embodiments, a through hole 112 is provided on a barrel wall of the lens barrel 11, the through hole 112 is proximal to the circuit board 20, and the lens barrel 11 is penetrated out by the electric connecting portion 31 through the through hole 112. A sealing member 313 may be provided at a position of the electric connecting portion 31 corresponding to the through hole 112. The sealing member 313 may include a sealing rubber sleeve, a sealing rubber ring, or the like. The lens element 12 and the lens barrel 11 may be in a sealed connection, the electric heating portion 32 may be disposed in the lens barrel 11, and then sealing between the electric connecting portion 31 and the lens barrel 11 may be implemented by the sealing member 313, thereby implementing waterproof of the heating coil.

In some embodiments, the position of the electrical connection portion 31 corresponding to the through hole 112 may also be filled with a glue.

In an embodiment of the camera module 100 having the heating function referring to FIG. 2, the electric heating portion 32 may be in an annular shape, and the electric heating portion 32 may be disposed at the inner side of the lens element corresponding to the light incident end 14 of the lens 10. The electric heating portion 32 with the annular shape may avoid blocking the light incident from the lens 10 while satisfying the heating function. In a further alternative embodiment, a heat-conductive medium 34 may be provided between the electric heating portion 32 and the lens element corresponding to the light incident end 14 of the lens 10, and the heat-conductive medium 34 may include a heat-conductive silicone grease or other paste-like heat-conductive materials, thereby improving heat transfer between the electric heating portion 32 and the lens element 12 and heating the lens element as soon as possible.

The various technical features of the above embodiments may be combined in any way. To make the description concise, not all possible combinations of the various technical features in the above embodiments have been described. However, as long as there is no contradiction in the combinations of these technical features, the combinations should be considered within the scope of the description.

The above-described embodiments express only several embodiments of the present invention, which are described in a more specific and detailed manner, but are not to be construed as a limitation on the scope of the present invention. For the skill in the art, several deformations and improvements can be made without departing from the conception of the present invention, all of which fall within the scope of protection of the present invention. Therefore, the scope of protection of the present invention shall be subject to the attached claims.

## Claims

1. A camera module having a heating function, **characterized by** comprising a lens, an electric heating apparatus, a circuit board, and a housing,
wherein the lens comprises a lens barrel and a lens group mounted in the lens barrel;
the electric heating apparatus comprises an electric connecting portion and an electric heating portion, an end of the electric connecting portion is electrically connected to the electric heating portion, another end of the electric connecting portion is provided with a first conductive connector, and the electric heating portion is located in the lens barrel;
the circuit board is provided with a second conductive connector, and the first conductive connector is welded to the second conductive connector; the circuit board is provided with a power-supply circuit electrically connected to the second conductive connector; and a through hole is provided on a barrel wall of the lens barrel, the through hole is proximal to the circuit board, and the lens barrel is penetrated out by the electric connecting portion through the through hole; and
the housing is provided with a lens element mounting portion for mounting the lens, the lens is mounted at a position of the lens element mounting portion, and the circuit board is disposed in the housing.

2. The camera module having the heating function of claim 1, wherein the electric connecting portion comprises a flexible circuit board, or the electric connecting portion comprises a wire.

3. The camera module having the heating function of claim 1, wherein the electric connecting portion comprises a flexible circuit board; and the electric heating portion comprises an electric heating sheet, and the electric heating sheet comprises a substrate and a heating wire arranged inside the substrate or on a surface of the substrate; or the electric heating portion comprises a heating wire formed on a surface of the flexible circuit board or inside the flexible circuit board.

4. The camera module having the heating function of claim 1, wherein the lens group comprises two or more lens elements arranged at intervals along an optical axis of the lens, and the electric heating portion is disposed at an inner side of one of the two or more lens elements corresponding to a light incident end of the lens.

5. The camera module having the heating function of claim 4, wherein the circuit board is disposed at a light emitting end of the lens, the circuit board is connected and fixed to the lens barrel, and a photosensitive element disposed on the circuit board is configured to convert light emitted by the lens into an image signal.

6. The camera module having the heating function of claim 1, wherein the electric connecting portion located inside the lens barrel is denoted as an inner electric connecting portion, the electric connecting portion located outside the lens barrel is denoted as an outer electric connecting portion, and the outer electric connecting portion is connected to an outer wall of the lens barrel by bonding.

7. The camera module having the heating function of claim 6, wherein an inner wall of the lens barrel is provided with an accommodating groove, and the accommodating groove is configured to accommodate the inner electric connecting portion.

8. The camera module having the heating function of claim 1, wherein a sealing member is provided at a position of the electric connecting portion corresponding to the through hole.

9. The camera module having the heating function of claim 4, wherein the electric heating portion is in an annular shape, and the electric heating portion is disposed at the inner side of the one of the two or more lens elements corresponding to the light incident end of the lens.

10. The camera module having the heating function of claim 9, wherein a heat-conducting medium is provided between the electric heating portion and the one of the two or more lens elements corresponding to the light incident end of the lens.
